# EUROPÄISCHE PATENTSCHRIFT

(11) **EP 1 903 342 B1**
(45) Veröffentlichungstag und Bekanntmachung des Hinweises auf die Patenterteilung: **04.11.2015**
(21) Anmeldenummer: 07017936.1
(22) Anmeldetag: 13.09.2007
(51) Int. Cl.: G01R 31/02

(54) **Verfahren und Anordnung zur Detektion einer Spule**
Method and system for identifying a coil
Procédé et agencement destinés à la détection d'une bobine

(30) Priorität: 22.09.2006 DE 102006045319
(43) Veröffentlichungstag der Anmeldung: 26.03.2008
(73) Patentinhaber: JUNGHANS Microtec GmbH, 78655 Dunningen-Seedorf (DE)
(72) Erfinder: Kölbli, Bertram, 60323 Frankfurt am Main (DE); Bug, Bernhard, 36124 Eichenzell (DE); Zinell, Alexander, 78048 Villingen-Schwenningen (DE); Leonhardt, Martin, 78733 Aichhalden (DE)
(74) Vertreter: Keil & Schaafhausen Patent- und Rechtsanwälte

(56) Entgegenhaltungen:
- JP-A- 4 101 509
- JP-A- 61 004 975
- JP-A- 2002 288 811
- JP-A- 2002 324 710

## Beschreibung

Die Erfindung betrifft ein Verfahren und eine Anordnung zur Detektion einer Spule in einer elektronischen Schaltung gemäß dem Oberbegriff der Ansprüche 1 und 7.

Derartige Schaltungen sind weit verbreitet. Sie werden insbesondere in einem Spannungsbereich zwischen Masse und einer meist positiven Speisespannung betrieben, welche von einer externen Spannungsquelle oder durch einen innerhalb der elektronischen Schaltung vorhandenen Kondensator mit entsprechender Spannungsstabilisierung zur Verfügung gestellt wird. Im Rahmen dieser Schrift wird unter einer Spule ein elektrisches Bauteil mit induktiven Eigenschaften und unter einem Kondensator ein elektrisches Bauteil mit kapazitiven Eigenschaften verstanden, die in der Lage sind, einen elektrischen Schwingkreis auszubilden.

Gegenstand der vorliegenden Erfindung sind also ein Verfahren und eine Anordnung, mit denen das Vorhandensein dieser Spule in der elektrischen Schalnung festgestellt werden kann. Eine typische Verwendung der vorliegenden Erfindung ist daher eine Schaltung, in der die Spule eine induktive Schnittstelle zu einer externen Wechselstrom-Spannungsversorgung und/oder zur Datenübertragung darstellt. Derartige Schaltungen werden beispielsweise verwendet, um nach Abtrennen oder Kurzschließen der Spule als auslösendem Ereignis einen vorgegeben Programmablauf zu starten. Daher ist es wichtig, das Entfernen der Spule innerhalb der elektronischen Schaltung zuverlässig feststellen zu können. Bei einem vollständigen Entfernen der Spule liegen die Spulenanschlüsse in der Spaltung frei, so dass ein hochohmiger Widerstand zwischen den beiden Spulenanschlüssen festgestellt werden kann. Im Falle eines Kurzschlusses der Spulenanschlüsse kann jedoch dagegen kein Widerstand festgestellt werden. Je nach Einsatzort der Schaltung kann es auch vorkommen, dass nach dem Entfernen der Spule ein ohmscher Widerstand festgestellt wird, der dem reinen ohmschen Widerstand der Spule entspricht, beispielsweise wenn die Spulenanschlüsse verdreckt sind oder mit einem schwach leitenden Medium in Kontakt kommen.

Daher kann durch einfache Messung des ohmschen Widerstands zwischen den Spulenanschlüssen in der elektrischen Schaltung nicht zuverlässig auf das Vorhandensein bzw. Entfernen einer Spule in der Schaltung geschlossen werden.

Aus der JP 61004975 (Patent Abstracts of Japan) ist eine Schaltung zum Feststellen eines Drahtbruchs einer Spule bekannt, die mit einer Z-Diode einen elektrischen Schwingkreis bildet. Ein erster Spulenanschluss ist an eine Spannung E₁ angeschlossen, der zweite Spulenanschluss kann über eine Diode mit Spannungspulsen beaufschlagt werden, die über einen an dem zweiten Spulenanschluss mittels eines Spannungsteilers angeschlossenen Analog-DigitalWandler ausgewertet werden, um den Bruch eines Spulendrahtes festzustellen.

In der JP 2002288811 (Patent Abstracts of Japan) und der JP 04101509 (Patent Abstracts of Japan) sind Schaltungen zum Feststellen des Trennens einer Spule aus einem Schaltkreis beschrieben, die das Vorliegen einer Oszillationsfrequenz auswerten, um eine angeschlossene Spule zu erkennen, wobei der Schaltung eine Oszillationsfrequenz mittels einer selbstoszillierenden Schaltung aufgeprägt und deren Verhalten ausgewertet wird.

Die JP 2002324710 (Patent Abstracts of Japan) beschreibt eine Überprüfungschaltung für die Anwesenheit einer Induktivität, bei der ein Abriss der Spule anhand eines hohen Widerstandswerts und ein Kurzschluss der Spule anhand eines niedrigen Widerstandswerts festgestellt wird. Hierzu sind zwei Komparatoren vorgesehen.

Aufgabe der vorliegenden Erfindung ist es, eine Spule in einer elektrischen Schaltung zuverlässig detektieren zu können.

Diese Aufgabe wird mit den Merkmalen der Ansprüche 1 und 7 gelöst. Bei dem erfindungsgemäßen Verfahren ist insbesondere vorgesehen, dass der elektrische Schwingkreis mit einem Impuls angeregt wird, der während der Schwingung an einem an der Spule abgreifbaren ersten Spulenanschluss zeitweilig einen außerhalb des vorgegebenen Spannungsbereichs liegenden Spannungswert erzeugt. Dieser Spannungswert, der innerhalb der elektronischen Schaltung nur dann erreicht werden kann, wenn ein elektronisches Bauteil mit induktiven Eigenschaften an den ersten Spulenanschluss angeschlossen ist, zeigt daher zuverlässig das Vorhandensein der Spule an. Wird dieser Spannungswert dagegen nicht festgestellt, kann davon ausgegangen werden, dass in der elektronischen Schaltung an dem ersten Spulenanschluss keine Spule angeschlossen ist bzw. diese entfernt wurde.

Dies wird festgestellt, indem der außerhalb des vorgesehenen Spannungsbereichs liegende Spannungswert durch Abtasten der Flanke des abgegriffenen Spannungssignals ermittelt wird. Dazu wird aus der an dem ersten Spulenanschluss unmittelbar abgegriffenen Spannung mittels eines in Basis-Schaltung betriebenen NPN-Transistors ein Spannungssignal erzeugt, welches nur dann eine das Fehlen der Spule andeutende negative oder positive Flanke in dem Spannungsverlauf aufweist, wenn an dem ersten Spulenanschluss eine Spannung anliegt, die außerhalb des vorgegebenen Spannungsbereichs der elektronischen Schaltung liegt.

Da das Auftreten von außerhalb des Betriebsspannungsbereichs liegenden Spannungen in elektronischen Schaltungen häufig Schäden an elektronischen Bauteilen verursachen kann, ist es zur Absicherung dieser Bauteile sinnvoll, die an dem ersten Spulenanschluss abgegriffene bzw. davon abgeleitete Spannung über eine Diode abzusichern. Dazu kann die Diode vorzugsweise an dem Eingang des Spannungsdetektors gegen Masse geschaltet sein. Hierfür eignet sich insbesondere eine Schottkydiode, welche ein besonders schnelles Schaltverhalten aufweist und eine kleinere Flussspannung als parasitäre Dioden einer angeschlossenen Siliziumschaltung besitzt. Deshalb wird sie früher leitend und schützt so die Siliziumschaltung.

In diesem Fall ist es möglich, die an dem ersten Spulenanschluss abgegriffene Spannung an einem Porteingang eines Mikroprozessors zu erfassen. Da ein Mikroprozessor bzw. dessen Porteingänge lediglich mit einem begrenzten Spannungsbereich in der Regel zwischen Masse und einer maximalen, meist positiven Speisebespannung beaufschlagt werden können, kann ein derartiger Porteingang gegen das Auftreten hoher Spannung in einer Polung durch die vorbeschriebene Diode zuverlässig geschützt werden.

Erfindungsgemäß ist es besonders vorteilhaft, wenn das Abgreifen der Spannung an dem ersten Spulenanschluss mittels elektrischer Bauteile erfolgt, die Teil einer Gleichrichterschaltung sind. In diesem Fall kann die Spule dem induktiven Anschluss der elektronischen Schaltung an eine vorgelagerte Schaltung dienen, beispielsweise zur Energieversorgung und/oder Programmierung. Durch die Wirkung des Gleichrichters wird dabei gleichzeitig eine Schutzfunktion für den Porteingang des Mikroprozessors erreicht, die insbesondere mit der zuvor beschriebenen Diode die möglichen Eingangsspannungen an dem Portanschluss auf einen zulässigen Spannungsbereich begrenzt.

Teil einer solchen Gleichrichterschaltung kann ein NPN-Transistor sein, über den die an dem ersten Spulenanschluss anliegende Spannung abgegriffen wird. Dazu wird der NPN-Transistor vorzugsweise invers und in Basisschaltung betrieben. Auf diese Weise kann der hinter dem NPN-Transistor liegende Porteingang vor hohen, oberhalb der maximalen Speisespannungen liegenden Spannungen geschützt werden. Daher ist die Verwendung eines NPN-Transistors auch dann sinnvoll, wenn dieser nicht Teil einer Gleichrichterschaltung ist.

Gemäß einer besonders vorteilhaften Ausgestaltung des erfindungsgemäßen Verfahrens kann die an dem ersten Spulenanschluss abgegriffene und beispielsweise an dem Porteingang des Mikroprozessors anliegende Spannung auch zur Bestimmung der Frequenz einer von außen auf die Spule aufgebrachten Wechselspannung herangezogen werden, beispielsweise wenn die Quarzstabilisierung der elektronischen Schaltung nicht ausreichend genau ist. Damit kann dieses Signal zur Kalibrierung der verwendeten Frequenzen und sogar zur Erkennung von Modulationen bei der Informationsübertragung beispielsweise im Rahmen einer Programmierung verwendet werden.

Bei einer erfindungsgemäßen Anordnung zur Detektion einer Spule in einer mit einer Gleichspannung in einem vorgegebenen Spannungsbereich betriebenen elektronischen Schaltung mit einer Spule und einem Kondensator, welche einen elektronischen Schwingkreis bilden, ist zur Lösung der erfindungsgemäßen Aufgabe gemäß den Merkmalen des Anspruchs 7 insbesondere vorgesehen, dass ein erster Spulenanschluss der Spule an einen Pulsgeber zur Erzeugung eines Pulses und einen Spannungsdetektor zum Erkennen eines außerhalb des Spannungsbereichs der Gleichspannung liegenden Spannungswertes aufweist. Diese Anordnung kann besonders vorteilhaft zur Durchführung des vorbeschriebenen Verfahrens eingesetzt werden.

Dazu ist erfindungsgemäß der Spannungsdetektor über einen in Basisschaltung betriebenen NPN-Transistor an den ersten Spulenanschluss angeschlossen ist, wobei der NPN-Transistor wegen der höheren Spannungsfestigkeit der Kollektor-Basis-Strecke gegenüber der Emitter-Basis-Strecke vorzugweise invers betrieben wird.

Ferner kann zwischen dem NPN-Transistor bzw. dessen Emitter-Anschluss und dem Spannungsdetektor eine Schottkydiode gegen Masse geschaltet sein. Durch diese Anordnung können unterhalb des vorgegebenen Spannungsbereichs, innerhalb dessen die elektronische Schaltung betrieben wird, liegenden Spannungen soweit abgeschottet werden, dass das abgegriffene Spannungssignal auf den Porteingang eines insbesondere mit der Speisespannung betriebenen Mikroprozessors geschaltet werden kann.

Die Portein- bzw. -ausgänge des Mikroprozessors sind dann insbesondere der Spannungsdetektor und/oder der Impulsgeber.

Gemäß einer besonders bevorzugten Ausführungsform der vorliegenden Erfindung ist dem elektrischen Schwingkreis, welcher die Spule enthält, ein Gleichrichter nachgeschaltet. Dies ist gleichbedeutend damit, dass die Spule eine Schnittstelle der elektronischen Schaltung zu einer vorgelagerten Schaltung sein kann, welche insbesondere eine Wechselspannung zur Energieversorgung und/oder Programmierung der elektronischen Schaltung erzeugt.

Dabei kann der NPN-Transistor Teil des Gleichrichters sein und insbesondere die Aufgabe einer der Dioden einer Gleichrichter-Brückenschaltung aus vier Dioden übernehmen.

Das erfindungsgemäße Verfahren sowie die insbesondere zur Durchführung des Verfahrens einsetzbare Anordnung sind geeignet, das Entfernen einer Spule aus einer elektronischen Schaltung besonders zuverlässig zu detektieren. Daher können sie dann besonders vorteilhaft eingesetzt werden, wenn das Entfernen der Spule als auslösendes Ereignis für einen nachfolgend ablaufenden Vorgang, bspw. den Ablauf eines innerhalb der elektronischen Schaltung eingegebenen Programms, herangezogen wird.

Weitere Vorteile, Merkmale und Anwendungsmöglichkeiten der vorliegenden Erfindung ergeben sich auch aus der nachfolgenden Beschreibung eines Ausführungsbeispiels und der Zeichnung.

Es zeigen:
- Fig. 1: eine elektronische Schaltung mit Spulendetektion gemäß der vorliegenden Erfindung;
- Fig. 2: beispielhaft Spannungsverläufe an den Spulenanschlüssen S1 und S2 sowie dem Emitter-Ausgang des NPN-Transistors V4 aus Fig.1;
- Fig. 3: das an dem Spulenanschluss S1 abgegriffene Spannungssignal bei Vorhandensein einer Spule;
- Fig. 4: das an dem Spulenanschluss S1 abgegriffene Spannungssignal nach einem hochohmigen Abtrennen der Spule;
- Fig. 5: das an dem Spulenanschluss S1 abgegriffene Spannungssignal bei einer kurzgeschlossenen Spule und
- Fig.6: das an dem Spulenanschluss S1 abgegriffene Spannungssignal bei Ersetzung der Spule durch einen Widerstand.

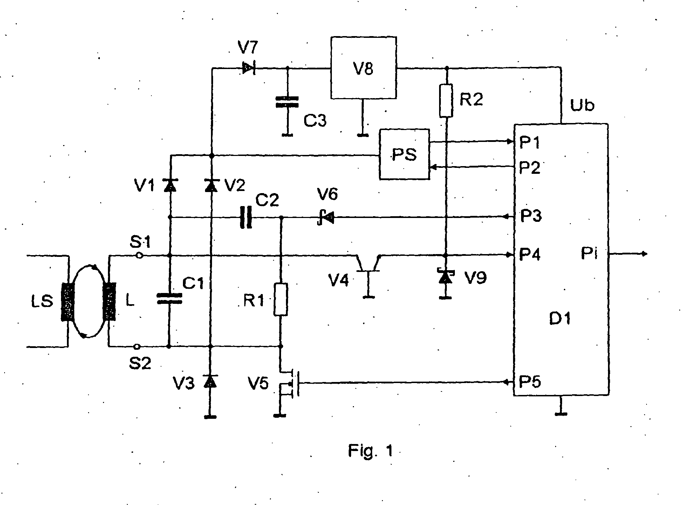

In Fig. 1 ist eine elektronische Schaltung mit einem Mikroprozessor D1 dargestellt. Die gesamte elektronische Schaltung wird über eine induktive Schnittstelle, welche eine Sendespule LS und eine Empfangsspule L aufweist, mit Energie versorgt. Ferner dient die Schnittstelle der Programmierung des Mikroprozessors D1. Dazu empfängt die Empfangsspule L ein in Fig. 1 durch Pfeile zwischen der Spule LS und der Spule L dargestelltes Wechselfeld von einer externen Wendespule LS. Die dabei übertragene Energie wird in einer nachfolgend noch genauer beschriebenen Weise gleichgerichtet und in einem Kondensator C3 gespeichert. Ein dem Kondensator C3 nachgeschalteter Spannungsregler V8 versorgt dann die gesamte elektronische Schaltung für eine gewisse Zeit mit einer stabilisierten Ausgangsspannung Ub auf Basis der in den Kondensator C3 gespeicherten Energie.

Durch eine Modulation des Trägersignals des magnetischen Wechselfeldes zwischen den Spulen LS, L können auch Daten an die elektronische Schaltung übertragen werden. Die Datenübertragung kann grundsätzlich bidirektional erfolgen und ist in Fig. 1 schematisch durch die Programmierschnittstelle PS angedeutet, die die in dem modulierten Trägersignal enthaltenen Programmierinformationen an den Porteingang P1 des Mikroprozessors D1 weiterleitet. Eventuelle Rückmeldungen von dem Mikroprozessor D1 erhält die Programmierschnittstelle PS über den Porteingang (bzw. den Portausgang) P2. Derartige Programmierschnittstellen PS sind bekannt und werden daher nachfolgend nicht erläutert.

Nach der Programmierung des Mikroprozessors D1 über die induktive Schnittstelle mit den Spulen LS, L soll der Mikroprozessor D1 nach Entfernen der Empfangsspule L entsprechend den einprogrammierten Parametern ein Programm abarbeiten, das an einem Ausgangsport Pi des Mikroprozessors D1 eine Reaktion in Abhängigkeit der programmierten Parameter auslöst. Das Entfernen der Spule L nach der Programmierung an dem ersten und zweiten Spulenanschluss S1 und S2 soll also als Startsignal für die Abarbeitung des in den Mikroprozessors D1 eingegeben Programms verwendet werden.

Um die Detektion der fehlenden Spule L mit hoher Sicherheit erreichen zu können, müssen verschiedene galvanische Leitzustände an den Spulenanschlüssen S1 und S2 nach dem Entfernen der Spule L erkannt werden. Das Entfernen der Spule kann beispielsweise als Abreißen der Spule bei einer Detonation von Munition oder dergleichen erfolgen, so dass der genaue Zustand im Bereich der Spulenanschlüsse S1 und S2 nicht genau bekannt ist. Insbesondere können die Spulenanschlüsse S1 und S2 nach dem Abreißen der Spule nicht nur hochohmig, sondern auch kurzgeschlossen sein oder einen ohmschen Widerstand aufweisen, dessen Wert in der Nähe des ohmschen Widerstands der Spule L selbst liegt.

Daher basiert die erfindungsgemäße Lösung zur Spulendetektion auf der Detektion von induktiven Eigenschaften der Spule L, die nicht nur den ohmschen Widerstand der Spule auf Vorhandensein misst, sondern Rückschlüsse darauf zulässt, ob die Induktivität der Spule L vorhanden ist oder nicht.

Dazu wird von dem Mikroprozessor D1 an dessen Portausgang P3 über eine Schottkydiode V6 ein positiver Spannungsimpuls ausgegeben, welcher die aus den beiden Kondensatoren C1 und C2 und der Spule L aufgebaute Teilschaltung so anregt, dass das schwingfähige System des elektrischen Schaltkreises aus der Spule L und dem Kondensator C1 auch Spannungen erzeugt, die gegen das Massepotential negativ sind und in der mit der positiven Ausgangs- bzw. Speisespannung Ub versorgten elektronischen Schaltung sonst nicht vorkommen.

Die durch einen Impuls angeregte Teilschaltung aus den Kondensatoren C1 und C2 und der Spule L ist grundsätzlich bereits bekannt (vgl. Speiser, "Impulsschaltungen", Springer Verlag 1963, Seite 133, Abbildung 150b), wobei bei den bekannten Schaltungen die gegen Masse bipolare Spannung dann mittels einer Diode so gleichgerichtet wird, dass nur die negativen Impulsanteile ausgegeben werden. Eine derartige Schaltung kann unter der Randbedingung eines eingeschränkten Betriebsspannungsbereichs nicht unmittelbar zur Detektion auf das Vorhandensein der Spule verwendet werden.

Sofern, was angesichts der Realisierung der elektronischen Schaltung in der Praxis besonders vorteilhaft ist, die Auswertung der an dem Spulenanschluss S1 abgegriffene Spannung durch einen Porteingang P4 des Mikroprozessors D1 erfolgen soll, ist es notwendig, diesen besonders zu schützen. Da ein Mikroprozessor ein digitales Bauelement ist, kann dieser an seinen Portein- bzw. -ausgängen nur Spannungen verarbeiten oder ausgeben, die zwischen Masse und seiner Betriebsspannung Ub, in der Regel eine positive Spannung, liegen. Negative Spannungen können also nicht auf seine Porteingänge gegeben werden, da sie den Mikroprozessor zerstören könnten. Genauso müssen aber auch hohe positive Spannungen an den Porteingängen vermieden werden, die über der Betriebsspannung Ub liegen.

Für die Realisierung der erfindungsgemäßen Detektionsschaltung mit einem Mikroprozessor D1 sind daher Absicherungen der Portein- bzw. -ausgänge P3 und P4 des Mikroprozesses D1 notwendig, die den Mikroprozessor D1 für die notwendige Messung mit den Spulenanschlüssen S1 und S2 verbindet. Bei der Energieversorgung und Programmierung können an diesen Spulenanschlüssen S1 und S2 Wechselspannung auftreten, die betragsmäßig deutlich über der positiven Betriebsspannung Ub bzw. im negativen Bereich liegen. Die Portein- bzw. -ausgänge P3 und P4 des Mikroprozessors D1 müssen also einerseits gegen die hohen Wechselspannungen der Programmierung und Energieversorgung geschützt werden und andererseits ist die negative Messspannung, die an dem Spulenanschluss S1 auftritt und zum Nachweis für das Vorhanden sein der Spule L dient, derart umzupolen bzw. zu begrenzen, dass der Porteingang P4 auch das Auftreten der negativen Spannungen erkennen kann.

Dies soll erfindungsgemäß einfach und mit möglichst wenigen Bauteilen realisiert werden. Die Schutzfunktion des Mikroprozessors D1 wird im Kern durch einen NPN-Transistor V4 realisiert, der invers und in Basisschaltung betrieben wird. Im Inversbetrieb verträgt der Transistor V4 hohe positive Spannungen an seinem mit dem Spulenanschluss S1 verbundenen Kollektor, wie sie in der Programmier- und Energieversorgungsphase auftreten, ohne dass diese auf den Porteingang P4 durchgeschaltet werden. Negative Spannungen an dem Spulenanschluss S1 machen dagegen die Kollektor-Basis-Diode des NPN-Transistors V4 leitend. In diesem Fall wirkt der Transistor V4 daher als Funktionspartner der Diode V2 bei positiven Spannungen an dem Spulenanschluss S2 und negativen Spannungen an dem Spulenanschluss S1. Auf Grund dieser Funktion bildet die Kollektor-Basis-Diode des Transistors V4 zusammen mit den Dioden V1 bis V3 also einen bekannten Brückengleichrichter für Wechselspannungen während der Programmierphase, mit dessen Hilfe die Energieversorgung und die Programmierphase des Mikroprozessors D1 bewerkstelligt werden können.

Würde der NPN-Transistor V4 in einer nicht invers betriebenen Basisschaltung verwendet, läge die maximal mögliche positive Spannung an dem Spulenanschluss S1 bei ca. 6 Volt, weil sonst die Emitter-Basis-Strecke des Transistors V4 durchbräche. Durch die Verwendung der Kollektor-Basis-Strecke als Steuerdiode der inversen Basisschaltung erhöht sich dagegen die Spannungsfestigkeit dieses Eingangs auf die maximale Kollektorspannung des Transistors V4.

In der Inversschaltung ist zwar die Stromverstärkung des Transistors V4 deutlich geringer; sie reicht jedoch in jedem Fall aus, um bei leitender Kollektor-Basis-Diode den mit dem Porteingang P4 des Mikroprozessors D1 verbundenen Emitter des Transistors V4 von der positiven Betriebsspannung Ub auf ein negatives Potential einer Diodenspannung zu bringen, beispielsweise von U_{P4} = -0,7 Volt. Damit eine an dem Porteingang P4 vorhandene parasitäre Eingangsdiode des Mikroprozessors D1 durch diese negative Spannung nicht leitend werden kann, ist zwischen dem Emitter des Transistors V4 und dem Porteingang P4 eine mit Masse verbundene Schottkydiode V9 eingefügt, welche sicherstellt, dass die an dem Porteingang P4 anliegende Spannung größer als U_{P4} = -0,4 Volt beträgt, also nach unten begrenzt wird. Diesen negativen Spannungsbereich kann der Mikroprozessor D1, insbesondere für kurze Zeit, verkraften.

Dadurch ist es erfindungsgemäß möglich, den elektrischen Schwingkreis mit einem Impuls so anzuregen, dass während der Schwingung an der Spule zeitweilig ein außerhalb des vorgegebenen Spannungsbereichs liegender, nämlich negativer Spannungswert erzeugt wird. Dieser Spannungswert kann unmittelbar am Porteingang P4 des Mikroprozessors D1 festgestellt werden. Diese vorteilhafte Schaltung wird mit wenigen zusätzlichen elektronischen Bauteilen erreicht, weil der NPN-Transistor V4 zum Abgreifen der negativen Spannung an dem Spulenanschluss S1 gleichzeitig Teil eines Brückengleichrichters im Programmierbetrieb der elektronischen Schaltung ist.

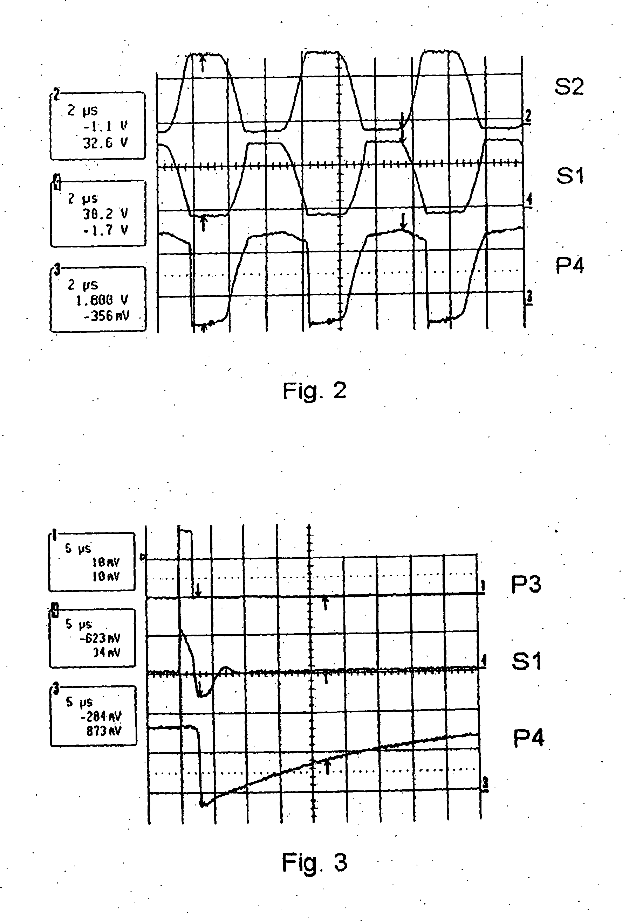

Zur Erläuterung des erfindungsgemäßen Betriebs werden nachfolgend typische Spannungsverläufe anhand der Fig. 2 bis 6 genauer erläutert.

Fig. 2 zeigt die Spannungsverläufe während der Programmierphase an den Spulenanschlüssen S1 und S2 sowie die an dem Spulenanschluss S1 abgegriffene Spannung, welche über den Emitterausgang des Transistors V4 am Porteingang P4 des Mikroprozessors D1 anliegt.

Wie zu erwarten, zeigt sich während der Programmierphase, in der die Spule L einer Wechselspannung ausgesetzt ist, der Verlauf dieser Wechselspannung an den Spulenanschlüssen S1 und S2, wobei der Spannungsbereich etwa von - 2V bis zu +30V reicht. Die hohen Spannungen an dem Spulenanschluss S1 werden durch den NPN-Transistor V4 auf eine Betriebsspannung von 1,8V herabgesetzt. Die negativen Spannungen, die durch den NPN-Transistor durchgeschaltet werden, werden durch die Schottkydiode V9 auf eine geringe negative Spannung in der Größenordnung von - 300 mV begrenzt. Daher kann der Porteingang P4 auch während der Programmierphase mit den an dem Spulenanschluss S1 abgegriffenen Spannungen beaufschlagt werden.

Die Frequenz der in Fig. 2 dargestellten Wechselspannung, die von einem externen Programmiergerät erzeugt wird, wird in der Regel quarzstabilisiert sein. Wenn aus technischen Gründen (Startverhalten, mechanische Robustheit etc.) der Takt der elektronischen Mikroprozessorschaltung nicht quarzstabilisiert werden kann, könnte beispielsweise über den Porteingang P4 des Mikroprozessors D1 eine Kalibration des gegebenenfalls ungenauen Oszillators der Mikroprozessorschaltung auf eine quarzgenaue Trägerfrequenz bewerkstelligt werden, um zum Beispiel eine genaue Zeitfunktion zu realisieren.

Auch ein Modulationsträgersignal könnte statt über die gesonderte Programmierstelle PS direkt über den Porteingang P4 erkannt werden, um die Programmierinformationen zu dekodieren. Damit kann die elektronische Schaltung insgesamt noch weiter vereinfacht werden.

Wenn die Programmierphase abgeschlossen ist, beginnt die Detektionsphase für die Erkennung einer Entfernung der Spule L, beispielsweise durch einen Spulenabriss. Dafür schaltet der Mikroprozessor D1 zunächst mit einer positiven Spannung an dem Portausgang P5 einen MOSFET-Transistor V5 dauerhaft in den leitenden Zustand, um den Spulenanschluss S2 auf Massepotential zu fixieren. Der MOSFET-Transistor V5 war während der Programmierphase durch ein 0-Signal gesperrt, um die Brückengleichrichtung des Trägers zu ermöglichen. Die maximal zulässige Drainspannung des MOSFET-Transistors V5 muss höher sein als die maximal auftretende Spannung an dem Spulenanschluss S2.

Anschließend gibt der Mikroprozessor D1 an dem Portausgang P3 periodisch Einzelimpulse von jeweils einigen Mikrosekunden Dauer aus, wie in der ersten Zeile von Fig. 3 zu erkennen. Diese werden über die Schottkydiode V6 und einen Widerstand R1 an die Schaltung mit den Kondensatoren C2, C1 und der Spule L weitergeleitet, um entsprechend der elektrischen Schwingung an dem Spulenanschluss S1 genau dann negative Spannungen zu erzeugen, wenn die Spule L an den Spulenanschlüssen S1 und S2 angeschlossen ist, weil dann die anregende Energie zwischen den Energiespeichern Spulen L und Kondensator C1 hin- und herpendelt.

Die Schottkydiode V6 schützt den Port P3 des Mikroprozessors D1 in der Programmierphase dabei gegen hohe positive Spannungen und erzeugt nur einen geringen Spannungsabfall, wenn die Anregungsimpulse in der Detektionsphase ausgegeben werden.

Wie in der zweiten Zeile von Fig. 3 zu erkennen, reagiert die Schaltung aus den Kondensatoren C1, C2 und der Spule L verursacht durch die Anregungsimpulse des Ausgangsports P3 entsprechend dem an dem Spulenanschluss S1 abgegriffenen Signal mit einem gedämpften, bipolaren Spannungsimpuls. Sobald die an dem Spulenanschluss S1 abgegriffene Spannung negativ wird, wird der NPN-Transistor V4 leitend und seine an den Porteingang P4 des Mikroprozessors D1 weitergeleitete Emitterspannung geht von einer positiven, von der Betriebsspannung Ub abgeleiteten Spannung auf die negative Klemmspannung der Schottkydiode V9 über. Die an dem Port P4 anliegende Spannung ist der untersten Zeile von Fig. 3 zu entnehmen. Diese in Fig. 3 erkennbare negative Flanke des an dem Porteingang P4 anliegenden Signal wird von dem Mikroprozessor D1 als intakt angeschlossene Spule erkannt und könnte zum Beispiel auch dazu verwendet werden, den Mikroprozessor D1 in einen stromsparenden Schlafmodus zu versetzen, aus dem er nach einer festen Zeit durch einen internen Timer-Interrupt zur Ausgabe eines neuen Anregungsimpulses geweckt wird. Diese Vorgehensweise kann wiederholt werden, bis keine negativen Flanken an dem an dem Porteingang P4 anliegenden Spannungssignal in Reaktion auf einen Anregungsimpuls mehr auftreten.

Das Fehlen der negativen Flanke des Signals an dem Porteingang P4 definiert dann den Zeitpunkt des Entfernens der Spule L und kann somit als Startsignal für ein Anwendungsprogramm, welches in dem Mikroprozessors D1 programmiert wurde, verwendet werden.

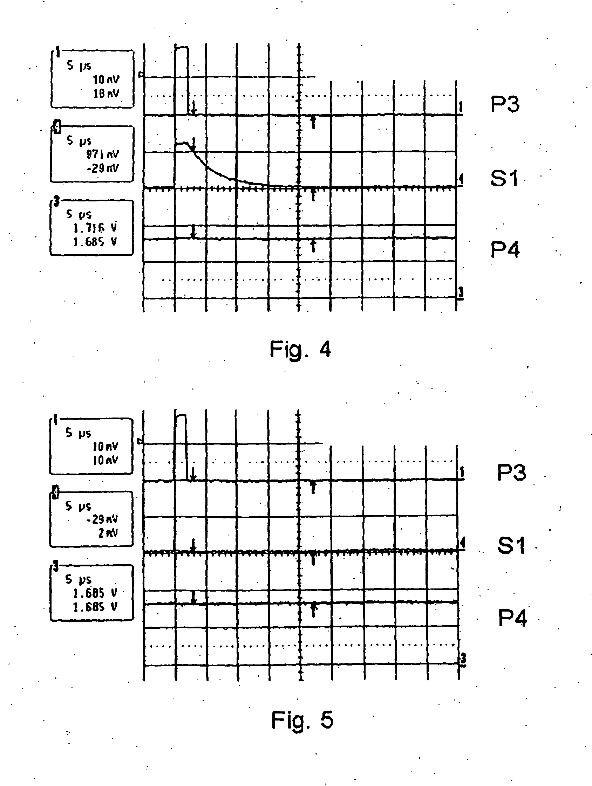

Anhand der Fig. 4, 5 und 6 wird das Verhalten der Detektionsschaltung nach einem Anregungsimpuls für den Fall dargestellt, dass keine Spule L an die Spulenanschlüsse S1 und S2 angeschlossen ist.

In Fig. 4 ist das Verhalten dargestellt, wenn die Spule L an den Spulenanschlüssen S1 und S2 hochohmig abgetrennt wurde, zwischen diesen also keine Leitung stattfindet. Da das System nun nicht mehr schwingfähig ist, stellt sich an dem Spulenanschluss S1 keine negative Spannung mehr ein. Deshalb wird der NPN-Transistor V4 nicht mehr leitend und der Porteingang P4 bleibt in Folge des Pullup-Widerstands R2 auf einem positiven Spannungs-Potential in Abhängigkeit von der Betriebsspannung Ub.

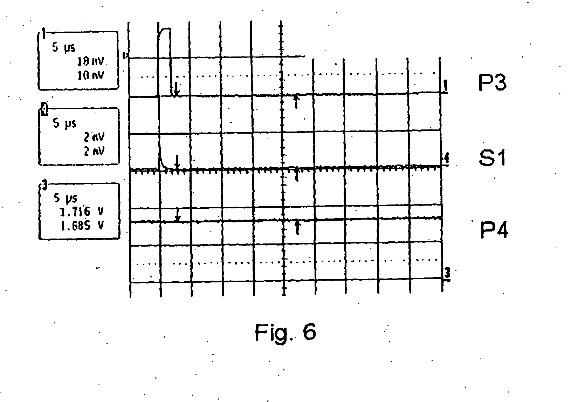

Fig. 5 und 6 zeigen ein entsprechendes Verhalten bei kurzgeschlossenen Spulenanschlüssen S1 und S2. Bei dem in Fig. 5 dargestellten Spannungsverlauf wurden die Spulenanschlüsse S1 und S2 sehr niederohmig kurzgeschlossen, bei dem Spannungsverlauf gemäß Fig. 6 dagegen mit einem 75-Ohm-Widerstand. In beiden Fällen entspricht die an dem Porteingang P4 anliegende Spannung dem durch die Betriebsspannung Ub vorgegebenen Spannungsniveau. Es tritt keine negative Spannung an dem Spulenanschluss S1 und daher auch keine negative Flanke an dem an dem Porteingang P4 anliegenden Spannungssignal auf.

Daher ist der erfindungsgemäße Vorschlag zur Detektion einer Spule L in einer elektronischen Schaltung auch in den Fällen sehr robust, in denen die Spule L durch einen ohmschen Widerstand zwischen den Spulenanschlüssen S1 und S2 ersetzt wurde.

### Bezugszeichenliste:

- D1: Mikroprozessor
- L: Empfangsspule
- S1, S2: erster und zweiter Spulenanschluss der Empfangsspule
- LS: Sendespule
- C1 bis C3: Kondensator
- V1 bis V3: Diode
- V4: NPN-Transistor
- V5: MOSFET-Transistor
- V6: Schottkydiode
- V7: Diode
- V8: Spannungsregler
- V9: Schottkydiode
- Ub: Betriebsspannung
- PS: Programmierschnittstelle
- P1 bis P5: Porteingänge, Portausgänge des Mikroprozessors
- Pi: Ausgangsport zur Initialisierung einer nachgeordneten Funktion
- R1, R2: Widerstände

## Patentansprüche

1. Verfahren zur Detektion einer Spule (L) in einer elektronischen Schaltung, die mit einer in einem vorgegebenen Spannungsbereich liegenden Gleichspannung (Ub) betriebenen wird und in der die Spule (L) mit einem Kondensator (C1) einen elektrischen Schwingkreis bildet, wobei der elektrische Schwingkreis mit einem Impuls angeregt wird, der während der Schwingung an einem an der Spule (L) abgreifbaren ersten Spulenanschluss (S1) zeitweilig einen außerhalb des vorgegebenen Spannungsbereichs liegenden Spannungswert erzeugt, und wobei dieser Spannungswert festgestellt wird, **dadurch gekennzeichnet, dass** die an dem ersten Spulenanschluss (S1) anliegende Spannung über einen in Basisschaltung betriebenen NPN-Transistor (V4) abgegriffen wird, indem der außerhalb des vorgegebenen Spannungsbereichs liegende Spannungswert durch Abtasten der negativen oder positiven Flanke des Spannungssignals ermittelt wird.

2. Verfahren nach Anspruch 1, **dadurch gekennzeichnet, dass** der NPN-Transistor (V4) invers betrieben wird.

3. Verfahren nach einem der Ansprüche 1 bis 2, **dadurch gekennzeichnet, dass** die an dem ersten Spulenanschluss (S1) abgegriffene Spannungspolarität an einem Porteingang (P4) eines Mikroprozessors (D1) erfasst wird.

4. Verfahren nach Anspruch 3, **dadurch gekennzeichnet, dass** der Porteingang (P4) des Mikroprozessors (D1) über eine Schottky-Diode (V9) abgesichert wird.

5. Verfahren nach einem der vorhergehenden Ansprüche, **dadurch gekennzeichnet, dass** das Abgreifen der Spannung an dem ersten Spulenanschluss (S1) mittels elektrischer Bauteile (V4) erfolgt, die Teil einer Gleichrichterschaltung (V1, V2, V3, V4) sind.

6. Verfahren nach einem der vorhergehenden Ansprüche, **dadurch gekennzeichnet, dass** die an dem ersten Spulenanschluss (S1) anliegende Spannung zur Bestimmung der Frequenz einer von außen auf die Spule (L) aufgebrachten Wechselspannung herangezogen wird.

7. Anordnung zur Detektion einer Spule (L) in einer mit einer Gleichspannung (Ub) in einem vorgegebenen Spannungsbereich betriebenen elektronischen Schaltung mit einer Spule (L) und einem Kondensator (C1), welche einen elektrischen Schwingkreis bilden, wobei ein erster Spulenanschluss (S1) der Spule (L) an einen Impulsgeber (P3, D1) zur Erzeugung eines Pulses und einen Spannungsdetektor (P4, D1) zum Erkennen eines außerhalb des Spannungsbereichs der Gleichspannung (Ub) liegenden Spannungswertes angeschlossen ist, **dadurch gekennzeichnet, dass** der Spannungsdetektor (P4, D1) über einen in Basisschaltung betriebenen NPN-Transsistor (V4) an den ersten Spulenanschluss (S1) angeschlossen ist.

8. Anordnung nach Anspruch 7, **dadurch gekennzeichnet, dass** der NPN-Transistor (V4) zur Erhöhung seiner Spannungsfestigkeit invers betrieben wird.

9. Anordnung nach Anspruch 7 oder 8, **dadurch gekennzeichnet, dass** zwischen dem NPN-Transistor (V4) und dem Spannungsdetektor (P4, D1) eine Schottkydiode (V9) gegen Masse geschaltet ist.

10. Anordnung nach einem der Ansprüche 7 bis 9, **dadurch gekennzeichnet, dass** der Spannungsdetektor und der Impulsgeber Portein- bzw. -ausgänge (P4, P3) eines Mikroprozessors (D1) sind.

11. Anordnung nach einem der Ansprüche 7 bis 10, **dadurch gekennzeichnet, dass** dem elektrischen Schwingkreis ein Gleichrichter (V1, V2, V3, V4) nachgeschaltet ist.

12. Anordnung nach Anspruch 11, **dadurch gekennzeichnet, dass** der NPN-Transistor (V4) Teil des Gleichrichters (V1, V2, V3, V4) ist.

13. Verwendung eines Verfahrens nach einem der Ansprüche 1 bis 6 und/ oder einer Anordnung nach einem der Ansprüche 7 bis 12 zum Festellen des Entfernens einer Spule (L) aus einer elektronischen Schaltung, welche über die Spule (L) als Empfängerspule mit Energie versorgt wird, wobei die elektronische Schaltung einen über die Spule (L) programmierbarenen Mikroprozessor (D1) aufweist, der dazu eingerichtet ist, nach dem Entfernen der Spule (L) ein Programm abzuarbeiten.

## Claims

1. A method for the detection of a coil (L) in an electronic circuit, which is operated with a DC voltage (Ub) located in a prescribed voltage range, and in which the coil (L), together with a capacitor (C1), forms an electrical oscillating circuit, wherein the electrical oscillating circuit is excited with a pulse, which during the oscillation temporarily generates a voltage value located outside the prescribed voltage range, which can be tapped on a first coil terminal connection (S1) on the coil (L), and wherein the said voltage value is determined, **characterised in that**, the voltage located at the first coil terminal connection (S1) is tapped via an NPN transistor (V4) operated in the basic circuit, **in that** the voltage value lying outside the prescribed voltage range is determined by sampling of the negative or positive flank of the voltage signal.

2. The method according to claim 1, **characterised in that** the NPN transistor (V4) is operated inversely.

3. The method according to one of the claims 1 to 2, **characterised in that** the polarity of the voltage tapped at the first coil terminal connection (S1) is registered at an entry port (P4) of a microprocessor (D1).

4. The method according to claim 3, **characterised in that** the entry port (P4) of the microprocessor (D1) is secured via a Schottky diode (V9).

5. The method according to one of the preceding claims, **characterised in that** the tapping of the voltage at the first coil terminal connection (S1) takes place by means of electrical components (V4), which are part of a rectifier circuit (V1, V2, V3, V4).

6. The method according to one of the preceding claims, **characterised in that** the voltage located at the first coil terminal connection (S1) is used for purposes of determining the frequency of an external AC voltage applied onto the coil (L).

7. An arrangement for the detection of a coil (L) in an electronic circuit, which is operated with a DC voltage (Ub) located in a prescribed voltage range; the electronic circuit has a coil (L) and a capacitor (C1), which form an electrical oscillating circuit, wherein a first coil terminal connection (S1) of the coil (L) is connected to a pulse generator (P3, D1) for purposes of generating a pulse, and is also connected to a voltage detector (P4, D1) for purposes of detecting a voltage value located outside the voltage range of the DC voltage (Ub), **characterised in that** the voltage detector (P4, D1) is connected to the first coil terminal connection (S1) via an NPN transistor (V4) operated in the basic circuit.

8. The arrangement according to claim 7, **characterised in that** the NPN transistor (V4) is operated inversely for purposes of increasing its dielectric strength.

9. The arrangement according to claim 7 or 8, **characterised in that** between the NPN transistor (V4) and the voltage detector (P4, D1) a Schottky diode (V9) is connected to ground.

10. The arrangement according to one of the claims 7 to 9, **characterised in that** the voltage detector and the pulse generator are port inputs and outputs (P4, P3) respectively of a microprocessor (D1).

11. The arrangement according to one of the claims 7 to 10, **characterised in that** a rectifier (V1, V2, V3, V4) is connected downstream of the electrical oscillating circuit.

12. The arrangement according to claim 11, **characterised in that** the NPN transistor (V4) is part of the rectifier (V1, V2, V3, V4).

13. A use of a method according to one of the claims 1 to 6, and/or an arrangement according to one of the claims 7 to 12, for purposes of determining the removal of a coil (L) from an electronic circuit, which is supplied with energy via the coil (L) as a receiver coil, wherein the electronic circuit has a microprocessor (D1) that can be programmed via the coil (L), which microprocessor is constituted for the purpose of executing a program after the removal of the coil (L).

## Revendications

1. Procédé pour la détection d'une bobine (L) dans un circuit électronique, lequel fonctionne avec une tension continue (Ub) située dans une plage de tensions prescrite et dans lequel la bobine (L) forme, avec un condensateur (C1), un circuit électrique oscillant, le circuit électrique oscillant étant excité avec une impulsion qui génère temporairement, pendant l'oscillation, une valeur de tension située en-dehors de la plage de tensions prescrite, au niveau d'une première connexion de bobine (S1), pouvant être prélevée sur la bobine (L), et cette valeur de tension étant constatée, **caractérisé en ce que** la tension appliquée à la première connexion de bobine (S1) est prélevée par l'intermédiaire d'un transistor NPN (V4) fonctionnant en connexion en base commune **en ce que** la valeur de tension située en-dehors de la plage de tensions prescrite est déterminée par exploration du flanc négatif ou positif du signal de tension.

2. Procédé selon la revendication 1, **caractérisé en ce que** le transistor NPN (V4) fonctionne de manière inverse.

3. Procédé selon l'une des revendications 1 à 2, **caractérisé en ce que** la polarité de tension prélevée au niveau de la première connexion de bobine (S1) est détectée à un port d'entrée (P4) d'un microprocesseur (D1).

4. Procédé selon la revendication 3, **caractérisé en ce que** le port d'entrée (P4) du microprocesseur (D1) est sécurisé via une diode de Schottky (V9).

5. Procédé selon l'une des revendications précédentes, **caractérisé en ce que** le prélèvement de la tension au niveau de la première connexion de bobine (S1) s'effectue au moyen de composants électriques (V4), lesquels font partie d'un circuit redresseur (V1, V2, V3, V4).

6. Procédé selon l'une des revendications précédentes, **caractérisé en ce que** la tension appliquée à la première connexion de bobine (S1) est prise en compte pour la détermination de la fréquence d'une tension alternative appliquée depuis l'extérieur à la bobine (L).

7. Agencement pour la détection d'une bobine (L) dans un circuit électronique fonctionnant avec une tension continue (Ub) dans une plage de tensions prescrite avec une bobine (L) et un condensateur (C1), lesquels forment un circuit électrique oscillant, une première connexion de bobine (S1) de la bobine (L) étant raccordée à un générateur d'impulsions (P3, D1) pour générer une impulsion et à un détecteur de tension (P4, D1) pour reconnaître une valeur de tension située en-dehors de la plage de tensions de la tension continue (Ub), **caractérisé en ce que** le détecteur de tension (P4, D1) est raccordé, via un transistor NPN (V4) fonctionnant en connexion en base commune, à la première connexion de bobine (S1).

8. Agencement selon la revendication 7, **caractérisé en ce que** l'on fait fonctionner le transistor NPN (V4) de manière inverse pour l'augmentation de sa résistance au claquage.

9. Agencement selon la revendication 7 ou 8, **caractérisé en ce qu'**une diode de Schottky (V9) est commutée à la masse entre le transistor NPN (V4) et le détecteur de tension (P4, D1).

10. Agencement selon l'une des revendications 7 à 9, **caractérisé en ce que** le détecteur de tension et le générateur d'impulsions sont des ports d'entrée ou de sortie (P4, P3) d'un microprocesseur (D1).

11. Agencement selon l'une des revendications 7 à 10, **caractérisé en ce qu'**un redresseur (V1, V2, V3, V4) est monté en aval du circuit électrique oscillant.

12. Agencement selon la revendication 11, **caractérisé en ce que** le transistor NPN (V4) fait partie du redresseur (V1, V2, V3, V4).

13. Utilisation d'un procédé selon l'une des revendications 1 à 6 et/ou d'un agencement selon l'une des revendications 7 à 12 pour la constatation de l'élimination d'une bobine (L) d'un circuit électronique, lequel est alimenté en énergie via la bobine (L) en tant que bobine réceptrice, le circuit électronique présentant un microprocesseur (D1) pouvant être programmé via la bobine (L) lequel est étudié pour exécuter un programme après l'élimination de la bobine (L).
